(19)

Europäisches
Patentamt
European
Patent Office
Office européen
des brevets

(11) **EP 4 621 932 A1**

(12) **EUROPEAN PATENT APPLICATION**

(43) Date of publication:
**24.09.2025 Bulletin 2025/39**

(21) Application number: **25152516.8**

(22) Date of filing: **17.01.2025**

(51) International Patent Classification (IPC):
$H01M\ 10/44^{(2006.01)}$   $H02J\ 7/00^{(2006.01)}$

(52) Cooperative Patent Classification (CPC):
**H01M 10/44; H02J 7/0071; H02J 7/00712;
H02J 7/007182; H02J 7/007184**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **20.03.2024 KR 20240038629**

(71) Applicant: **SAMSUNG SDI CO., LTD.
Yongin-si, Gyeonggi-do 17084 (KR)**

(72) Inventors:
• **Kim, Yeonwoo
17084 Yongin-Si, Gyeonggi-do (KR)**
• **Cho, Haein
17084 Yongin-Si, Gyeonggi-do (KR)**

(74) Representative: **Gulde & Partner
Patent- und Rechtsanwaltskanzlei mbB
Berliner Freiheit 2
10785 Berlin (DE)**

(54) **CHARGING CONTROL METHOD AND APPARATUS FOR BATTERY**

(57)     Provided is a charging control method and apparatus for battery. The charging control method may include determining a charging completion voltage of constant current charging or constant power charging as a first value based on a target charging energy of a battery, before a voltage value of the battery reaches the first value during the constant current charging or the constant power charging, determining whether a time point at which the voltage value of the battery reaches the first value is predicted to be near a local minimum point of a voltage rise rate of the battery, and maintaining or changing the charging completion voltage based on a result of determining whether the time point at which the voltage value of the battery reaches the first value is predicted to be near the local minimum point of the voltage rise rate of the battery.

FIG. 8

**Description**

FIELD

The present disclosure relates to a charging control method and apparatus.

BACKGROUND

Unlike primary batteries that are not designed to be (re)charged, secondary (or rechargeable) batteries are batteries that are designed to be discharged and recharged. Low-capacity secondary batteries are used in portable, small electronic devices, such as smart phones, feature phones, notebook computers, digital cameras, and camcorders, while large-capacity secondary batteries are widely used as power sources for driving motors in hybrid vehicles and electric vehicles and for storing power (e.g., home and/or utility scale power storage). A secondary battery generally includes an electrode assembly composed of a positive electrode and a negative electrode, a case accommodating the same, and electrode terminals connected to the electrode assembly.

The above information disclosed in this Background section is for enhancement of understanding of the background of the present disclosure, and therefore, it may contain information that does not constitute related (or prior) art.

SUMMARY

An aspect of the present disclosure is to provide a method and apparatus for controlling a charging completion voltage based on a voltage profile of a battery.

However, the technical problem to be solved by the present disclosure is not limited to the above problem, and other problems not mentioned herein, and aspects and features of the present disclosure that would address such problems, will be clearly understood by those skilled in the art from the description of the present disclosure below.

According to some embodiments of the present disclosure to realize the objectives herein, a charging control method includes: determining a charging completion voltage of constant current charging or of constant power charging as a first value based on a target charging energy of a battery; before a voltage value of the battery reaches the first value during the constant current charging or the constant power charging, determining whether a time point at which the voltage value of the battery reaches the first value is predicted to be near a local minimum point of a voltage rise rate of the battery; and maintaining or changing the charging completion voltage based on a result of determining whether the time point at which the voltage value of the battery reaches the first value is predicted to be near the local minimum point of the voltage rise rate of the battery.

According to an embodiment, the determining of whether the time point at which the voltage value of the battery reaches the first value is predicted to be near the local minimum point of the voltage rise rate of the battery may include: calculating at least one of a second derivative value or a third derivative value of a voltage of the battery based on determining that the voltage value of the battery reaches a first voltage of the first value minus a first predetermined value during the constant current charging or the constant power charging; and determining whether the time point at which the voltage value of the battery reaches the first value is predicted to be near the local minimum point of the voltage rise rate of the battery based on at least one of the second derivative value or the third derivative value.

According to an embodiment, the determining of whether the time point at which the voltage value of the battery reaches the first value is predicted to be near the local minimum point of the voltage rise rate of the battery may include: calculating a second derivative value of a voltage of the battery based on determining that the voltage value of the battery reaches the first voltage including the first value minus a first predetermined value during the constant current charging or the constant power charging; and determining whether the second derivative value is positive.

According to an embodiment, the determining of whether the time point at which the voltage value of the battery reaches the first value is predicted to be near the local minimum point of the voltage rise rate of the battery may further include determining that the time point at which the voltage value of the battery reaches the first value is not predicted to be near the local minimum point of the voltage rise rate of the battery based on determining that the second derivative value is positive.

According to an embodiment, the determining of whether the time point at which the voltage value of the battery reaches the first value is predicted to be near the local minimum point of the voltage rise rate of the battery may include: calculating a third derivative value of the voltage of the battery based on determining that the second derivative value is not positive; and determining whether the third derivative value is within a predetermined range.

According to an embodiment, the determining of whether the third derivative value is within the predetermined range may include: determining whether the third derivative value is greater than or equal to a second predetermined value.

According to an embodiment, the determining of whether the time point at which the voltage value of the battery reaches the first value is predicted to be near the local minimum point of the voltage rise rate of the battery may further include: determining that the time point at which the voltage value of the battery reaches the first value is not predicted to be near the local minimum point of the voltage rise rate of the battery based on determining that the third derivative value is not within the predetermined range.

According to an embodiment, the determining of whether the time point at which the voltage value of the battery reaches the first value is predicted to be near the local minimum point of the voltage rise rate of the battery may further include: determining that the time point at which the voltage value of the battery reaches the first value is predicted to be near the local minimum point of the voltage rise rate of the battery based on determining that the third derivative value is within the predetermined range.

According to an embodiment, the maintaining or the changing of the charging completion voltage may include: maintaining the charging completion voltage as the first value based on determining that the time point at which the voltage value of the battery reaches the first value is not predicted to be near the local minimum point of the voltage rise rate of the battery.

According to an embodiment, the maintaining or changing of the charging completion voltage may include: changing the charging completion voltage to a second value based on determining that the time point at which the voltage value of the battery reaches the first value is predicted to be near the local minimum point of the voltage rise rate of the battery.

According to an embodiment, when the first value plus a third predetermined value is equal to or less than an operating upper limit voltage of the battery, the second value may be the first value plus the third predetermined value, and when the first value plus the third predetermined value is greater than the operating upper limit voltage of the battery, the second value may be the operating upper limit voltage.

According to an embodiment, the second derivative value may include a value obtained by differentiating the voltage of the battery twice by an amount of charge and/or time, and the third derivative value may include a value obtained by differentiating the voltage of the battery three times by an amount of charge and/or time.

According to an embodiment, the charging control method may further include switching to constant voltage charging based on determining that the voltage value of the battery reaches the charging completion voltage.

According to some embodiments of the present disclosure to realize the objectives herein, a charging control apparatus includes: a memory storing one or more instructions; and a processor configured to execute the stored one or more instructions to: determine a charging completion voltage of constant current charging or constant power charging as a first value based on a target charging energy of a battery; before a voltage value of the battery reaches the first value during the constant current charging or the constant power charging, determine whether a time point at which the voltage value of the battery reaches the first value is predicted to be near a local minimum point of a voltage rise rate of the battery; and maintain or change the charging completion voltage based on a result of determining whether the time point at which the voltage value of the battery reaches the first value is predicted to be near the local minimum point of the voltage rise rate of the battery.

According to an embodiment, when executing the stored one or more instructions, the processor may be further configured to: calculate at least one of a second derivative value or a third derivative value of a voltage of the battery based on determining that the voltage value of the battery reaches a first voltage of the first value minus a first predetermined value during the constant current charging or the constant power charging; and determine whether the time point at which the voltage value of the battery reaches the first value is predicted to be near the local minimum point of the voltage rise rate of the battery based on at least one of the second derivative value or the third derivative value.

According to an embodiment, when executing the stored one or more instructions, the processor may be further configured to: calculate a second derivative value of a voltage of the battery based on determining that the voltage value of the battery reaches the first voltage of the first value minus a first predetermined value during the constant current charging or the constant power charging; and determine whether the second derivative value is positive.

According to an embodiment, when executing the stored one or more instructions, the processor may be further configured to: determine that the time point at which the voltage value of the battery reaches the first value is not predicted to be near the local minimum point of the voltage rise rate of the battery based on determining that the second derivative value is positive.

According to an embodiment, when executing the stored one or more instructions, the processor may be further configured to: calculate a third derivative value of the voltage of the battery based on determining that the second derivative value is not positive; and determine whether the third derivative value is within a predetermined range.

According to an embodiment, the processor may be further configured to: determine that the time point at which the voltage value of the battery reaches the first value is not predicted to be near the local minimum point of the voltage rise rate of the battery based on determining that the third derivative value is not within the predetermined range.

According to an embodiment, when executing the stored one or more instructions, the processor may be further configured to: determine that the time point at which the voltage value of the battery reaches the first value is predicted to be near the local minimum point of the voltage rise rate of the battery based on determining that the third derivative value is within the predetermined range.

According to some embodiments of the present disclosure, during charging, the charging completion voltage may be set to avoid a voltage range having a long charging time, e.g., a voltage range having a low voltage rise rate, and resources such as a charging time may be reduced.

However, aspects and features of the present disclosure are not limited to those described above, and other aspects and features not mentioned will be clearly understood by a person skilled in the art from the detailed description, described below.

BRIEF DESCRIPTION OF THE DRAWINGS

The following drawings attached to the present specification illustrate embodiments of the present disclosure, and further describe aspects and features of the present disclosure together with the detailed description of the present disclosure. Thus, the present disclosure should not be construed as being limited to the drawings:

FIG. 1 illustrates a perspective diagram showing an example of a battery cell, according to some embodiments of the present disclosure.
FIG. 2 illustrates a perspective view showing an example of a battery module, according to some embodiments of the present disclosure.
FIGS. 3 and 4 illustrate perspective views showing an example of a battery pack, according to some embodiments of the present disclosure.
FIG. 5 illustrates an example of a charging method, according to some embodiments of the present disclosure.
FIG. 6 illustrates a configuration diagram illustrating an example of a charging system, according to some embodiments of the present disclosure.
FIG. 7 illustrates a charge profile example according to various charging completion voltages.
FIG. 8 illustrates a voltage profile example for the same battery used in the example of FIG. 7.
FIG. 9 illustrates a flowchart showing an example of a charging control method, according to some embodiments.

DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C," "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

Secondary batteries may be recharged and used repeatedly after being discharged, and the charging method may affect the usability and performance of the secondary batteries, such as the charging time and the amount of degradation. Therefore, efforts are being made and are identified herein to improve the charging method for secondary batteries.

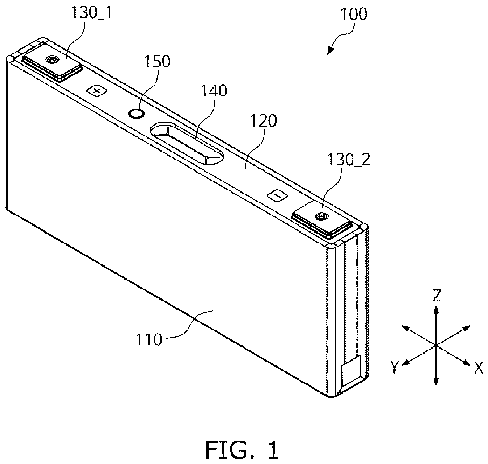

FIG. 1 illustrates a perspective diagram showing an example of a battery cell 100 according to some embodiments of the present disclosure. Referring to FIG. 1, the battery cell 100 may include an electrode assembly including electrodes (e.g., at least one wound or laminated electrode assembly including a separator, i.e., an insulator, provided between a positive electrode and a negative electrode), a case 110 in which the electrode assembly is disposed, and a cap plate 120 coupled to an opening of the case 110. The battery cell 100 shown in FIG. 1 may be a secondary cell.

Each of the positive electrode and the negative electrode may include a current collector made of a thin metal foil having a coated portion on which an active material is coated and an uncoated portion on which an active material is not coated. The positive electrode and the negative electrode are wound after interposing the separator, which is an insulator, therebetween. However, the present disclosure is not limited thereto, and the electrode assembly may have a structure in which a positive electrode and a negative electrode each made of a plurality of sheets, are alternately stacked with a separator interposed therebetween. In addition, the electrode assembly may have any appropriate structure including electrodes.

The case 110 forms the overall contour of the battery cell 100, and may be formed of a conductive metal such as aluminum (Al), an Al alloy, or nickel (Ni)-plated steel. Further, the case 110 may provide a space in which the electrode assembly is accommodated. In FIG. 1, the case 110 is shown as a prismatic case and the battery cell 100 is shown as a prismatic battery cell, but the scope of the present disclosure is not limited thereto. The battery cell 100 may be a battery cell having any shape such as a prismatic shape, a cylindrical shape, or a pouch shape.

The cap plate 120 may be coupled to the opening of the case 110 to seal the case 110. The case 110 and the cap plate 120 may be formed of a conductive material. In an embodiment, the top end of the case 110 may be open, and the cap plate 120 may seal the open top end of the case 110.

A positive electrode terminal 130_1 electrically connected to a positive electrode and a negative electrode terminal 130_2 electrically connected to a negative electrode may be coupled to the cap plate 120. For example, the positive and negative terminals 130_1 and 130_2 may be disposed to protrude outwardly through the cap plate 120. The positions of the positive and negative terminals 130_1 and 130_2 may be changed (relative to the positions shown in FIG. 1).

According to an embodiment, a vent 140 may be provided on at least one side of the battery cell 100 (e.g., the top side of the battery cell 100, i.e., the cap plate 120, in the shown example). The vent 140 may be configured to open in a case where an internal pressure higher than or equal to a predetermined threshold pressure is detected in the battery cell 100. In addition or in another example, the vent 140 may be configured to open in a case where the internal temperature exceeds a predetermined threshold temperature. With this configuration, the vent 140 may prevent explosion of the battery cell 100 or prevent a chain exothermic reaction of other battery cells arranged around the battery cell 100.

In an embodiment, the cap plate 120 may include an electrolyte inlet 150. For example, the electrolyte inlet 150 may be a through-hole provided in the cap plate 120, and may be formed such that electrolyte is injected into the case 110 through the electrolyte inlet 150 after the cap plate 120 is coupled and sealed to an opening of the case 110. The electrolyte inlet 150 may be sealed with a sealing member after the electrolyte is injected.

The battery cell 100 may be a lithium (Li) battery cell, a sodium (Na) battery cell, or the like. However, the scope of the present disclosure is not limited thereto, and the battery cell 100 can include any batteries capable of repeatedly providing electricity by being charged and discharged. In an embodiment in which the battery cell 100 is a Li battery cell, the battery cell 100 may be used in an electric vehicle (EV) due to superior lifetime characteristics and superior high rate characteristics. For example, the battery cell 100 may be used in a hybrid vehicle such as a plug-in hybrid electric vehicle (PHEV). In addition, the Li battery cell may be used in a field in which a large amount of power storage is used. For example, the Li battery cell may be used in electric bicycles, power tools, and the like.

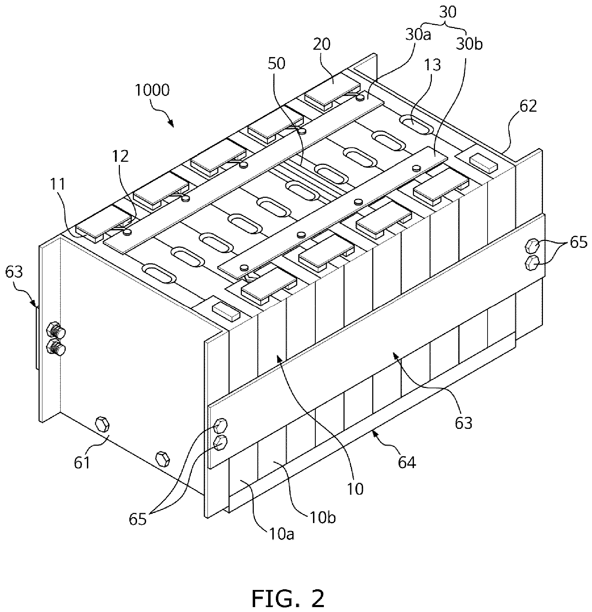

FIG. 2 illustrates a perspective view showing an example of a battery module 1000 according to some embodiments of the present disclosure.

Battery packs and battery modules will be described in the following as distinct concepts, but the present disclosure is not limited thereto.

Referring to FIG. 2, the battery module 1000 according to one or more embodiments of the present disclosure includes terminal units 11 and 12, a plurality of battery cells 10 arranged in one direction, a connection tab 20 connecting a battery cell 10a to an adjacent battery cell 10b, and a protection circuit module 30 having one end connected to the connection tab 20. The protection circuit module 30 may include a battery management system (BMS). Further, the connection tab 20 may include a body portion in contact with the terminal units 11 and 12 between the adjacent battery cells 10a and 10b and an extension portion extending from the body portion and connected to the protection circuit module 30. The connection tab 20 may be, for example, a bus bar.

Each battery cell 10 may include a battery case, an electrode assembly received (or accommodated) in the battery case, and an electrolyte. The electrode assembly and the electrolyte react electrochemically to store and release (e.g., generate) energy. Terminal parts 11 and 12 electrically connected to the connection tab 20 and a vent 13 as a discharge passage for gas generated inside the battery case may be provided on one side of (e.g., an upper side of) the battery cell 10. The terminal parts 11 and 12 of the battery cell 10 may be a positive electrode terminal 11 and a negative electrode terminal 12 having different polarities from each other, and the terminal parts 11 and 12 of the adjacent battery cells 10a and 10b may be electrically connected to each other in series or parallel by the connection tab 20, to be described in more detail below. Although a serial connection has been described as an example, the connection structure is not limited thereto, and various connection structures may be employed as desired or necessary. In addition, the number and arrangement of battery cells is not limited to the structure shown in FIG. 2 and may be changed as desired or necessary.

The plurality of battery cells 10 may be arranged in (e.g., may be stacked in) one direction so that the wide surfaces of the battery cells 10 face each other, and the plurality of battery cells 10 may be fixed by the housings 61, 62, 63, and 64. The housings 61, 62, 63, and 64 may include a pair of end plates 61 and 62 facing the wide surfaces of the battery cell 10 and a side plate 63 and a bottom plate 64 connecting the pair of end plates 61 and 62 to each other. The side plate 63 may support side surfaces of the battery cells 10, and the bottom plate 64 may support bottom surfaces of the battery cells 10. In addition, the pair of end plates 61 and 62, the side plate 63 and the bottom plate 64 may be connected by bolts 65 and/or any other suitable fastening members and methods known to those of ordinary skill in the art.

The protection circuit module 30 may have electronic components and protection circuits mounted thereon and may be electrically connected to connection tabs 20, to be described in more detail later. The protection circuit module 30 includes a first protection circuit module 30a and a second protection circuit module 30b extending along the direction in which the plurality of battery cells 10 are arranged in different locations. The first protection circuit module 30a and the second protection circuit module 30b may be spaced from each other at a suitable interval (e.g., a predetermined interval) and arranged parallel to each other to be electrically connected to adjacent connection tabs 20, respectively. For example, the first protection circuit module 30a extends on one side of the upper portion of the plurality of battery cells 10 along the direction in which the plurality of battery cells 10 are arranged, and the second protection circuit module 30b extends to the other upper side of the plurality of battery cells 10 along the direction in which the plurality of battery cells 10 are arranged. The second protection circuit module 30b may be spaced from the first protection circuit module 30a at a suitable interval (e.g., a predetermined interval) with the vents 34 interposed therebetween but may be disposed parallel to the first protection circuit module 30a. As such, the two protection circuit modules are spaced from each other side-by-side along the direction in which the plurality of battery cells 10 are arranged, thereby reducing or minimizing the area of the printed circuit board (PCB) constituting the protection circuit module. By separately configuring the protection circuit module into two protection circuit modules, unnecessary PCM area can be reduced or minimized. In addition, the first protection circuit module 30a and the second protection circuit module 30b may be connected to each other by a conductive connection member 50. One side of the conductive connection member 50 is connected to the first protection circuit module 30a, and the other side thereof is connected to the second protection circuit module 30b so that the two protection circuit modules 30a and 30b can be electrically connected with each other.

The connection may be performed by any one of soldering, resistance welding, laser welding, projection welding and/or any other suitable connection methods known to those of ordinary skill in the art.

In addition, the connection member 50 may be, for example, an electric wire. In addition, the connection member 50 may be made of a material having elasticity or flexibility. By the connecting member 50, it may be possible to check and manage whether the voltage, temperature, and/or current of the plurality of battery cells 10 are normal. For example, the information received by the first protection circuit module from connection tabs adjacent to the first protection circuit module, such as voltage, current, and/or temperature, and the information received from connection tabs adjacent to the second protection circuit module, such as voltage, current, and/or temperature, may be integrated and managed by the protection circuit module through the connection member 50.

In addition, when the battery cell 10 swells, shocks may be absorbed by the elasticity or flexibility of the connection member 50, thereby preventing the first and second protection circuit modules 30a and 30b from being damaged.

In addition, the shape and structure of the connection member 50 is not limited to the shape and structure shown in FIG. 2.

As described above, because the protection circuit module 30 is provided as the first and second protection circuit modules 30a and 30b, the area of the PCB constituting the protection circuit module can be reduced or minimized, and the space inside the battery module can be secured, which improves work efficiency by facilitating a fastening work for connecting the connection tab 20 and the protection circuit module 30 and repair work if (or when) an abnormality is detected in the battery module.

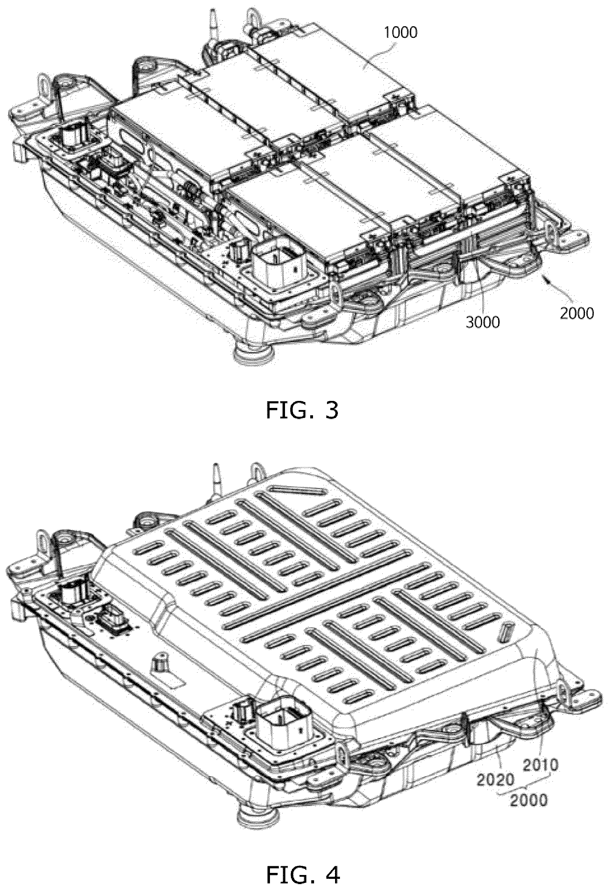

FIG. 3 illustrates a perspective view showing an example of a battery pack according to some embodiments of the present disclosure. FIG. 4 illustrates a perspective view showing an example of a battery pack, according to some embodiments. The battery pack may include a plurality of battery modules 1000 and a housing 2000 for accommodating the plurality of battery modules 1000. For example, the housing 2000 may include first and second housings 2010 and 2020 coupled in opposite directions through the plurality of battery modules 1000.

According to an embodiment, in a battery pack, a single battery module 1000 may be formed of a single cell stack instead of battery modules. The single cell stack may include a plurality of battery cells. In the cell stack, the battery cells may be arranged in a single direction, with the wide sides thereof facing each other. In an embodiment, each of the battery cells may have a vent on the top side. For example, each of the battery cells may be the battery cell shown in FIG. 1, but the battery cells are not limited thereto. The number and arrangement of the cell stacks and the battery cells are not limited to the structure shown in FIGS. 3 and 4, and may be modified as desired and/or as appropriate.

The battery modules 1000 or cell stacks may be electrically connected to each other using bus bars 3000, and the battery modules 1000 may be electrically connected to each other in a series/parallel manner or in a mixed series/parallel manner to achieve desired electrical output.

The battery cell may generate a large amount of heat during charging/discharging. The generated heat may be accumulated in the battery cell, thereby accelerating the deterioration of the battery cell. Accordingly, the battery pack may further include a cooling member to remove the generated heat and thereby suppress deterioration of the battery cell. The cooling member may be provided at the bottom of the accommodation space at where the battery cell is provided but is not limited thereto and may be provided at the top or side depending on the battery pack.

The battery cell may be configured such that exhaust gas generated inside the battery cell under abnormal operating conditions, also known as thermal runaway or thermal events, is discharged to the outside of the battery cell. The battery pack or the battery module may include an exhaust port for discharging the exhaust gas to prevent or reduce damage to the battery pack or module by the exhaust gas.

The battery pack may include a battery and a battery management system (BMS) for managing the battery. The battery management system may include a detection device, a balancing device, and a control device. The battery module may include a plurality of cells connected to each other in series and/or parallel. The battery modules may be connected to each other in series and/or in parallel.

The detection device may detect a state of a battery (e.g., voltage, current, temperature, etc.) to output state information indicating the state of the battery. The detection device may detect the voltage of each cell constituting the battery or of each battery module. The detection device may detect current flowing through each battery module constituting the battery module or the battery pack. The detection device may also detect the temperature of a cell and/or module on at least one point of the battery and/or an ambient temperature.

The balancing device may perform a balancing operation of a battery module and/or cells constituting the battery module. The control device may receive state information (e.g., voltage, current, temperature, etc.) of the battery module from the detection device. The control device may monitor and calculate the state of the battery module (e.g., voltage, current, temperature, state of charge (SOC), life span (state of health (SOH)), etc.) on the basis of the state information received from the detection device. In addition, on the basis of the monitored state information, the control device may perform a control function (e.g., temperature control, balancing control, charge/discharge control, etc.) and a protection function (e.g., over-discharge, over-charge, over-current protection, short circuit, fire extinguishing function, etc.). In addition, the control device may perform a wired or wireless communication function with an external device of the battery pack (e.g., a higher level controller or vehicle, charger, power conversion system, etc.).

The control device may control charging/discharging operation and protection operation of the battery. To this end, the control device may include a charge/discharge control unit, a balancing control unit, and/or a protection unit.

The battery management system is a system that monitors the battery state and performs diagnosis and control, communication, and protection functions, and may calculate the charge/discharge state, calculate battery life or state of health (SOH), cut off, as necessary, battery power (e.g., relay control), control thermal management (e.g., cooling, heating, etc.), perform a high-voltage interlock function, and/or may detect and/or calculate insulation and short circuit conditions.

A relay may be a mechanical contactor that is turned on and off by the magnetic force of a coil or a semiconductor switch, such as a metal oxide semiconductor field effect transistor (MOSFET).

The relay control has a function of cutting off the power supply from the battery if (or when) a problem occurs in the vehicle and the battery system and may include one or more relays and pre-charge relays at the positive terminal and the negative terminal, respectively.

In the pre-charge control, there is a risk of inrush current occurring in the high-voltage capacitor on the input side of the inverter when the battery load is connected. Thus, to prevent inrush current when starting a vehicle, the pre-charge relay may be operated before connecting the main relay and the pre-charge resistor may be connected.

The high-voltage interlock is a circuit that uses a small signal to detect whether or not all high-voltage parts of the entire vehicle system are connected and may have a function of forcibly opening a relay if (or when) an opening occurs at even one location on the entire loop.

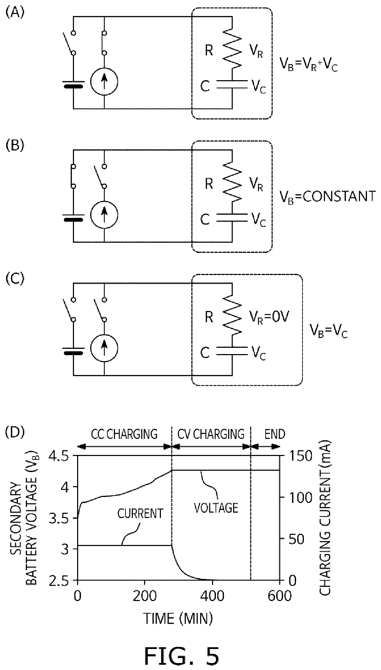

FIG. 5 illustrates an example of a charging method according to some embodiments of the present disclosure. According to an embodiment, the secondary battery may be charged by a CCCV charging method. The CCCV charging method is a charging method in which constant current (CC) charging is performed until the voltage reaches a predetermined voltage (e.g., a charging completion voltage), and then constant voltage (CV) charging is performed until the amount of current flowing decreases (e.g., becomes a final current value).

During CC charging, as shown in FIG. 5(A), a switch of a constant current power supply is turned on and a switch of a constant voltage power supply is turned off so that a constant current I flows through the secondary battery. During this period, because the current I is constant, a voltage VR applied to an internal resistor R is also constant according to Ohm's law (VR=R×I). Meanwhile, a voltage VC applied to a secondary battery capacitor C increases with time. Therefore, a secondary battery voltage VB may rise over time.

When (or if) the secondary battery voltage VB reaches a suitable or reference voltage (e.g., a predetermined voltage), for example, about 4.3 V, CC charging is switched to CV charging. During CV charging, as shown in FIG. 5(B), the switch of the constant voltage power supply is turned on and the switch of the constant current power supply is turned off so that the secondary battery voltage VB is constant. Meanwhile, the voltage VC applied to the secondary battery capacitor C increases with time. Because VB = VR + VC is satisfied, the voltage VR applied to the internal resistor R decreases with time. As the voltage VR applied to the internal resistor R decreases, the current I flowing through the secondary battery may also decrease according to Ohm's law (VR=R×I).

When (or if) the current I flowing through the secondary battery reaches a suitable or reference current (e.g., a predetermined current), for example, about 0.01 C, charging is terminated. When (or if) CCCV charging is finished, all switches are turned off and the current I becomes 0, as shown in FIG. 5(C). At this time, the voltage VR applied to the internal resistor R becomes 0 V. Accordingly, even when voltage drop is prevented across the internal resistor R, the secondary battery voltage VB does not substantively decrease.

FIG. 5(D) shows a graph of a secondary battery voltage VB and charging current during CCCV charging and after CCCV charging is terminated. Even after CCCV charging is terminated, the secondary battery voltage VB does not substantively decrease.

In addition or in another example, the secondary battery may be charged by a CPCV charging method. For example, according to the CPCV charging method, constant power (CP) charging may be performed until the voltage reaches a predetermined voltage (e.g., a charging completion voltage), and then constant voltage (CV) charging may be performed until the amount of current flowing decreases (e.g., becomes a final current value). In the following, charging by the CCCV charging method will be described as a main example for ease of explanation, but the scope of the present disclosure is not limited thereto, and a charging control method may be applied equally/similarly to charging by the CPCV charging method.

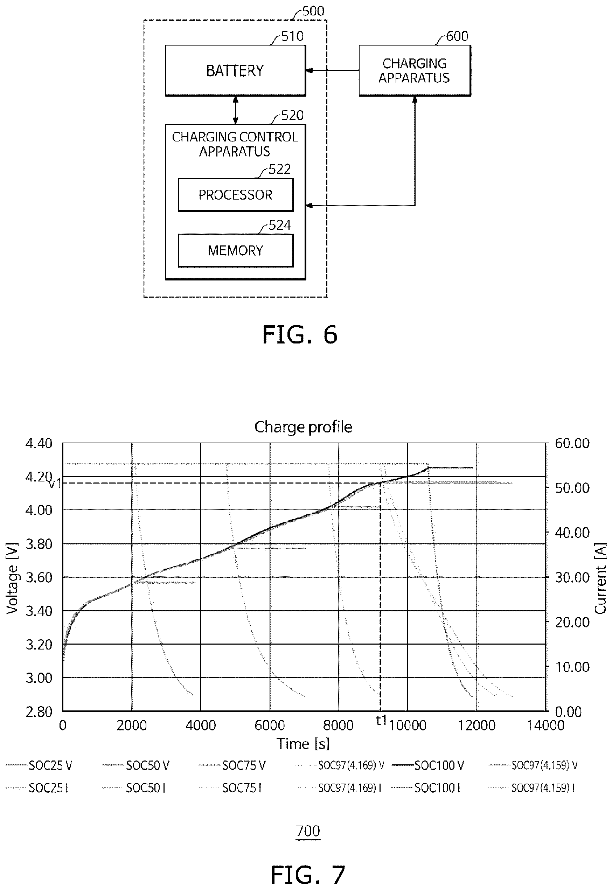

FIG. 6 illustrates a configuration diagram illustrating an example of a charging system according to some embodiments of the present disclosure. Referring to FIG. 6, the charging system may include a battery pack 500 and a charging apparatus 600. The battery pack 500 may include a battery 510 and a charging control apparatus 520. The charging apparatus 600 may be electrically connected to the battery 510 to supply power to the battery 510, and the charging control apparatus 520 may control the charging by, for example, determining and/or changing the charging completion voltage.

The battery 510 may include at least one battery cell (e.g., the battery cell 100 of FIG. 1), and the battery cell may be a rechargeable secondary battery. The number of battery cells included in the battery 510 and connections thereof may be determined based on, for example, an amount of power and/or a voltage for the battery pack 500. For example, the battery 510 may include a plurality of battery cells connected in series, in parallel, or in both series and parallel. In another example, the battery 510 may include only a single battery cell. The battery to which the charging control method according to some embodiments of the present disclosure is applied may be the battery 510, or may be at least one battery cell included in battery 510.

The charging control apparatus 520 may be an apparatus for controlling the charging of the battery 510. In an embodiment, the charging control apparatus 520 may refer to, or be included in, a battery management system (BMS) of the battery pack 500.

According to an embodiment, the charging control apparatus 520 may include a processor 522 and a memory 524. In some examples, the processor and memory are connected. The processor 522 may control overall operations for controlling the charging of the battery. For example, the processor 522 may store data in the memory 524, load data stored in the memory 524, and execute instructions (or program code) stored in the memory 524. The processor 522 may process instructions from a computer program by performing arithmetic, logic, and/or input/output operations to control the charging of the battery. In some examples, the processor may be configured to execute the stored instructions which may cause the processor to perform a method according to techniques described herein.

According to an embodiment, the processor 522 may be implemented using a general purpose processor, a central processing unit (CPU), a microprocessor, a digital signal processor (DSP), a controller, a microcontroller, a state machine, or the like. In some environments, the processor 522 may refer to an application-specific integrated circuit (ASIC), a programmable logic device (PLD), a field-programmable gate array (FPGA), or the like. In an embodiment, the processor 522 may also refer to a combination of processing devices, such as a combination of a DSP and a microprocessor, a combination of a plurality of microprocessors, a combination of one or more microprocessors coupled to a DSP core, or any other combination of such configurations.

The memory 524 may include any non-transitory computer-readable recording medium or storage medium. According to an embodiment, the memory 524 may include a non-transitory permanent mass storage device, such as read only memory (ROM), a disk drive, a solid state drive (SSD), flash memory, or the like. The memory 524 may store an operating system and at least one program code. For example, the memory 524 may store and/or may be configured to store one or more instructions (or program code) for performing the charging control method according to some embodiments of the present disclosure.

The memory 524 may store data generated by measuring at least one parameter of the battery 510. For example, the data stored in the memory may include charge and discharge current, a terminal voltage, and/or a temperature of the battery 510. The memory 524 may store program code and state of charge- open circuit voltage (SOC-OCV) data for estimating the SOC of the battery using the data generated by measuring the at least one parameter of the battery 510. The at least one parameter of the battery 510 may refer to a component or a variable, such as a terminal voltage, a charge/discharge current, and/or an ambient temperature of the battery 510.

According to some embodiments, the charging control apparatus may further include a voltage measuring portion, a current measuring portion, and/or a temperature measuring portion for measuring at least one parameter of the battery 510. According to an embodiment, the charging control apparatus may further include a communication module for communicating with other devices, such as a charging apparatus, an electronic control unit (ECU) of a vehicle, and the like. The voltage measuring portion may be configured to measure a voltage of the battery 510. The voltage measuring portion may be electrically coupled to the processor 522 to transmit and receive electrical signals. According to an embodiment, under the control of the processor 522, the voltage measuring portion may measure a voltage at opposite ends of the battery 510 and/or the battery cell at time intervals and output a signal indicating the magnitude of the measured voltage to the processor 522. At this time, the processor 522 may determine the voltage of the battery 510 and/or the battery cell from the signal output from the voltage measuring portion. For example, the voltage measuring portion may be implemented using a voltage measuring circuit commonly used in the art.

The voltage measuring portion may be configured to measure current in the battery. The voltage measuring portion may be electrically connected to the processor 522 to transmit and receive electrical signals. According to an embodiment, under the control of the processor 522, the voltage measuring portion may repeatedly measure the magnitude of the charging current or discharging current of the battery 510 and/or the battery cell at time intervals and output a signal indicating the magnitude of the measured current to the processor 522. At this time, the processor 522 may determine the magnitude of the current from the signal output from the voltage measuring portion. For example, the current sensor may be implemented using a Hall sensor or a sense resistor commonly used in the art.

The temperature measuring portion may be configured to measure the temperature of the battery 510. The temperature measuring portion may be electrically connected to the processor 522 to transmit and receive electrical signals. According to an embodiment, the temperature measuring portion may repeatedly measure the temperature of the secondary battery at time intervals and output a signal indicating the magnitude of the measured temperature to the processor 522. At this time, the processor 522 may determine the temperature of the battery from the signal output from the temperature measuring portion. For example, the temperature measuring portion may be implemented using a thermocouple commonly used in the art.

In addition, the processor 522 may estimate a state of charge (SOC) of the battery 510 using at least one of voltage measurements, current measurements, and temperature measurements for the battery 510. The SOC may be calculated as a number corresponding to a remaining amount of charge in the battery 510 in the range of 0% to 100%.

According to an embodiment, the processor 522 may estimate the SOC of the battery 510 by adding a charging current and a discharging current of the battery 510. Here, when the charging or discharging of the battery 510 begins, an initial value of the SOC may be determined using an open circuit voltage (OCV) of the battery 510 measured before the charging or discharging begins. In this regard, the processor 522 may estimate the SOC corresponding to the open circuit voltage of the battery 510 using an SOC-OCV lookup table that defines the SOC according to the open circuit voltage.

The processor 522 may control the charging of the battery 510 based on battery status information obtained by various methods, such as the methods described above. The battery state information may include a voltage, charge/-discharge current, a temperature, an SOC, an amount of degradation (e.g., a state of health (SOH), a resistance growth rate, or a capacity decay rate), and the like of the battery 510.

According to an embodiment, in performing the CCCV charging or the CPCV charging, the processor 522 may determine an initial charging completion voltage of the CC charging or the CP charging, and in a case where the determined initial charging completion voltage is determined to correspond to a voltage range having a low voltage increase rate, may adjust the charging completion voltage upward.

For example, the processor 522 may determine a charging completion voltage of the CC charging or the CP charging as a first value in performing the CCCV charging or the CPCV charging. For example, the processor 522 may determine the charging completion voltage as the first value based on at least one of a target charging energy and battery state information, such as a temperature, an SOC, and an amount of degradation of the battery 510.

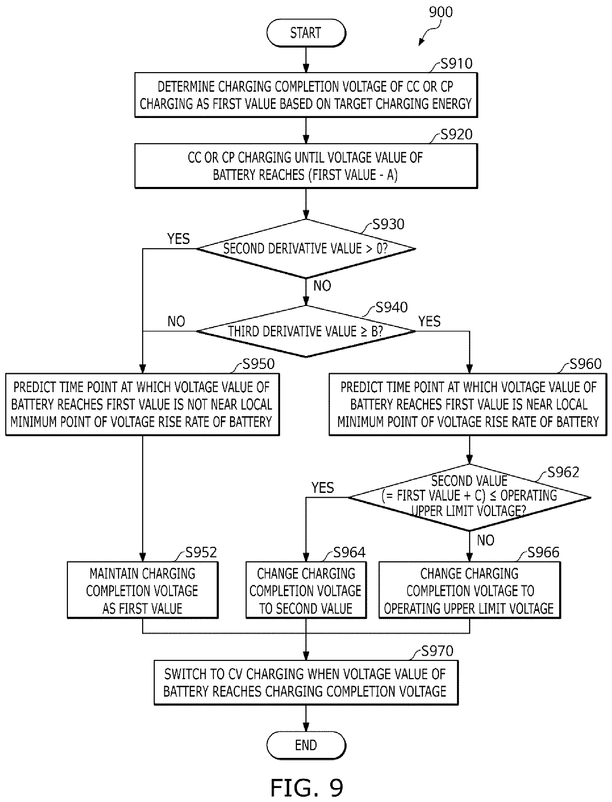

Thereafter, before the voltage value of the battery 510 reaches the first value during the constant current charging or the constant power charging, the processor 522 may determine whether a time point at which the voltage value of the battery 510 reaches the first value (e.g., the charging completion voltage value determined based on the battery state information) is predicted to be near a local minimum point of a voltage rise rate of the battery 510. In a case where (when) the time point at which the voltage value of the battery 510 reaches the first value is predicted to be near the local minimum point of the voltage rise rate of the battery 510, the processor 522 may change the charging completion voltage to a second value or an operating upper limit voltage. Accordingly, the charging completion voltage may be set to avoid a voltage range having a low voltage rise rate, and resources such as a charging time may be reduced. The process in which the processor 522 determines whether the time point at which the voltage value of the battery 510 reaches the first value is predicted to be near the local minimum point of the voltage rise rate of the battery 510 and the process in which the charging completion voltage is changed according to the determination result will be described in more detail later with reference to FIG. 9.

To perform the charging control described above, the processor 522 may appropriately control switches included in the battery pack 500.

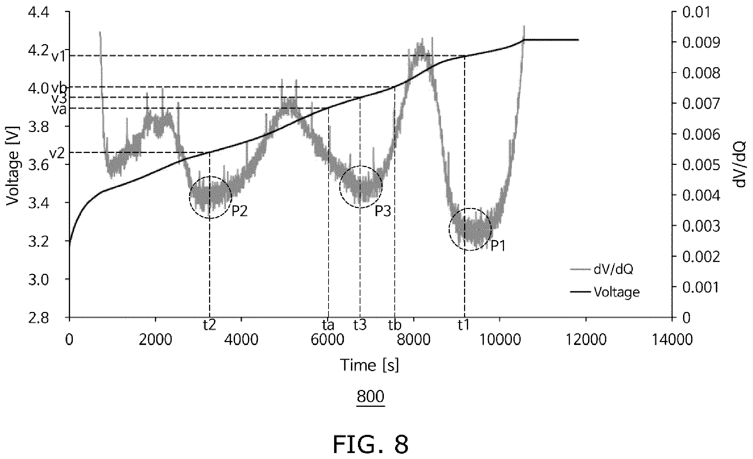

FIG. 7 illustrates a charge profile example 700 according to various charging completion voltages. FIG. 8 illustrates a voltage profile example 800 for the same battery used in the example of FIG. 7. Referring to FIGS. 7 and 8, the charge profile example 700 includes a time-voltage (V) graph and a time-current (I) graph for various charging completion voltages during the CCCV charging, and the voltage profile example 800 includes the time-voltage (V) graph and a time-voltage rise rate (dV/dQ) graph for the CCCV charging to 100% SOC.

Examining the voltage profile example 800 in FIG. 8, it can be seen that peaks P1, P2, and P3 (local minimum points) having a low voltage rise rate (e.g., dV/dQ) occur during charging of the battery. In some examples, the peaks may be referred to as valleys of the profile. The peaks P1, P2, and P3 may be caused by various reasons, such as the phase change of the material inside the battery. Without wishing to be bound by any particular theory, because the current decrease rate during constant voltage charging is also low in these peaks P1, P2, and P3, in a case where the constant voltage charging is performed with voltages v1, v2, and v3 near the peaks P1, P2, and P3, the time to reach the final current value may be increased, thereby resulting in a longer charging time.

Examining the charge profile example 700 in FIG. 7, it can be seen that in a case where the charging completion voltage is set to voltage values v1, v2, and v3 (e.g., 4.159 V and 4.169 V in FIG. 7) near the peaks P1, P2, and P3, the constant voltage charging time is particularly long compared to other cases. This tendency may also be seen in Table 1 below.

TABLE 1

| Charging Completion Voltage | CC | | ~CV 1/5C Cut-off | | | ~CV 1/50C Cut-off | | |
|---|---|---|---|---|---|---|---|---|
| V | Cumulative Capacity [Ah] | Cumulative Time [Min] | Cumulative Capacity [Ah] | Cumulative Time [Min] | CV Time [Min] | Cumulative Capacity [Ah] | Cumulative Time [Min] | CV Time [Min] |
| 3.569 | 32.1 | 34.9 | 35.1 | 39.1 | 4.3 | 40.3 | 63.7 | 28.9 |
| 3.770 | 72.6 | 78.8 | 75.9 | 83.6 | 4.8 | 82.5 | 116.8 | 38.0 |
| 4.016 | 118.0 | 128.1 | 120.9 | 132.2 | 4.1 | 125.3 | 153.7 | 25.6 |
| 4.159 | 140.9 | 153.0 | 152.0 | 169.0 | 16.0 | 164.4 | 216.7 | 63.7 |
| 4.169 | 142.7 | 155.0 | 153.6 | 170.4 | 15.5 | 163.3 | 209.1 | 54.1 |
| 4.250 | 162.3 | 176.2 | 164.9 | 179.8 | 3.63 | 168.6 | 197.2 | 21.0 |

Table 1 shows examples of the results of constant current charging at various charging completion voltages for the same battery used in the examples in FIGS. 7 and 8, followed by constant voltage charging with a final current value of 1/5C or 1/50C. Referring to a first example (a charging completion voltage 4.159 V and a final current value of 1/50C) and a second example (a charging completion voltage of 4.250 V, a final current value of 1/5C), it can be seen that almost similar capacities (164.4 ampere-hour (Ah) and 164.9 Ah, respectively) were charged. However, it can be seen that the constant voltage charging time of the first example, where the charging completion voltage corresponds to the peak P1, is particularly time-consuming, and the charging time of the first example is therefore 30 minutes or more longer than that of the second example.

Because the appearance of the peaks P1, P2, and P3 depends on the degradation history of the battery, the inventors have identified that it is very difficult to set the charging completion voltage to avoid the peaks P1, P2, and P3 before charging.

According to an embodiment of the present disclosure, the charging control apparatus may determine whether the time point at which the voltage of the battery reaches the charging completion voltage is predicted by the peaks P1, P2, and P3 of the voltage rise rate (e.g., near the local minimum point of the voltage rise rate) based on the voltage profile during charging. In a case where it is determined that the time point at which the voltage of the battery reaches the charging completion voltage is predicted by the peaks P1, P2, and P3 of the voltage rise rate (e.g., near the local minimum point of the voltage rise rate), the charging control apparatus may change the charging completion voltage.

For example, in a case where the charging completion voltage is set to v3 (corresponding to the peak P3 in FIG. 8), the charging control apparatus may determine whether the peaks P1, P2, and P3 of the voltage rise rate are predicted to be about to arrive based on the aspect of the voltage profile at the time point ta (<t3) at which the voltage value of the battery reaches va (<v3). In a case where the peaks P1, P2, and P3 of the voltage rise rate are predicted to be about to arrive, the charging control apparatus may adjust the charging completion voltage upward to vb (≥v3). Accordingly, the charging completion voltage may be set to avoid the voltage range of the peaks P1, P2, and P3 of the voltage rise rate (e.g., near the local minimum point of the voltage rise rate), and resources such as a charging time may be reduced. The process in which the charging control apparatus adjusts the charging completion voltage will be described in more detail below with reference to FIG. 9.

FIG. 9 illustrates a flowchart showing an example of a charging control method 900. According to an embodiment, the charging control method 900 may be started by a processor (e.g., at least one processor of the charging control apparatus) determining a first value of a charging completion voltage of constant current charging or constant power charging based on target charging energy in act S910. For example, the processor may determine the charging completion voltage of the constant current charging or the constant power charging as the first value based on at least a portion of the target charging energy and the battery state information including a temperature, a state of charge (SOC), an amount of degradation (e.g., a state of health (SOH), a resistance growth rate, and a capacity reduction rate), and the like of the battery to be charged.

Thereafter, before the voltage value of the battery reaches the first value during the constant current charging or constant power charging, the processor may determine whether the time point at which the voltage value of the battery reaches the first value is predicted to be near the local minimum point of the voltage rise rate of the battery. For example, the processor may calculate at least one of a second derivative value or a third derivative value of the voltage of the battery and, based on the at least one of the calculated second derivative value or the calculated third derivative value, determine whether the time point at which the voltage value of the battery reaches the first value is predicted to be near the local minimum point of the voltage rise rate of the battery. Here, the second derivative value may include a value obtained by differentiating the battery voltage twice by an amount of charge and/or time. In a specific example, the second derivative value may be a derivative value (e.g., $\frac{d}{dt}\left(\frac{dV}{dQ}\right)$ or $\frac{d}{dQ}\left(\frac{dV}{dQ}\right)$) obtained by differentiating once the voltage rise rate (e.g., dV/dQ) of the battery by time and/or an amount of charge, i.e., a first derivative value of the voltage rise rate. The third derivative value may include a derivative value obtained by differentiating the battery voltage three times by an amount of charge and/or time. As a specific example, the third derivative value may be a derivative value (e.g., $\frac{d^2}{dt^2}\left(\frac{dV}{dQ}\right)$ or $\frac{d^2}{dQ^2}\left(\frac{dV}{dQ}\right)$) obtained by twice differentiating the voltage rise rate of the battery (e.g., dV/dQ) by time and/or an amount of charge, i.e., the second derivative value of the voltage rise rate. As used herein, "first," "second," and "third" derivative values may refer to an order of the derivative.

In a specific example, first, the constant current charging or the constant voltage charging may be performed until the voltage value of the battery reaches the first value minus a first predetermined value (e.g., a positive real number a, in a specific example, 0.05 V) in act S920. Based on the determination that the voltage value of the battery reaches the first value minus the first predetermined value (e.g., a first voltage), the processor may calculate the second derivative value (e.g., $\frac{d}{dt}\left(\frac{dV}{dQ}\right)$) of the voltage of the battery and may determine whether the calculated second derivative value is positive in act S930. That is, the processor may start the determination at a time point just before the voltage value of the battery reaches the initially set charging completion voltage.

In a case where the second derivative value of the voltage is positive, this may indicate that the voltage rise rate (e.g., dV/dQ) is in an increasing range. That is, because the voltage rise rate is currently in the increasing range, the time point at which the voltage value of the battery reaches the first value (e.g., the initialized charging completion voltage) may not be predicted to be near the local minimum point of the voltage rise rate. Therefore, in a case where the second derivative value is determined to be positive, based on determining that the second derivative value is positive, the processor may determine that the time point at which the voltage value of the battery reaches the first value is not predicted to be near the local minimum point of the voltage rise rate of the battery in act S950.

On the other hand, in a case where the second derivative value is determined to be non-positive, based on the determination, the processor may calculate a third derivative value of the voltage of the battery and determine whether the calculated third derivative value is within a predetermined range in act S940. For example, the processor may determine that the third derivative value is greater than or equal to a second predetermined value (e.g., a real number B, in a specific example, -0.01). With respect to the voltage profile (e.g., the voltage profile of FIG. 8), in a case where the second derivative value is not positive (i.e., the voltage rise rate is currently in a decreasing range) and the third derivative value is greater than or equal to the second predetermined value, this may indicate that the local minimum point of the voltage rise rate is about to occur. Accordingly, in a case where the third derivative value is determined to be greater than or equal to the second predetermined value, based on determining the third derivative value is within the predetermined range, the processor may determine that the time point at which the voltage value of the battery reaches the first value is predicted to be near the local minimum point of the voltage rise rate of the battery in act S960.

On the other hand, even in a case where the second derivative value is not positive (i.e., even in a case where the current voltage rise rate is in the decreasing range), when the third derivative value is not greater than or equal to the second predetermined value, this may mean that the local minimum point of the voltage rise rate is not about to arrive. Accordingly, in a case where the third derivative value is determined to be not equal to or less than the second predetermined value and/or based on this determination, the processor may determine that the time point at which the voltage value of the battery reaches the first value is not predicted to be near the local minimum point of the voltage rise rate of the battery in act S950.

Thereafter, the processor may maintain or change the charging completion voltage based on a result of the determination of whether the time point at which the voltage value of the battery reaches the first value is predicted to be near the local minimum point of the voltage rise rate of the battery.

For example, in a case where it is determined that the time point at which the voltage value of the battery reaches the first value is not predicted to be near the local minimum point of the voltage rise rate of the battery, based on the determination, the processor may maintain the charging completion voltage at the first value in act S952.

On the other hand, in a case where it is determined that the time point at which the voltage value of the battery reaches the first value is predicted to be near the local minimum point of the voltage rise rate of the battery, based on the determination, the charging completion voltage may be adjusted upward to prevent the charging time of the constant voltage charge from increasing. For example, the processor may determine whether the second value obtained by adding a third predetermined value (e.g., a positive real number C, in a specific example, 0.05 V) to the first value is below the operating upper limit voltage in act S962. In a case where it is determined that the second value obtained by adding the third predetermined value to the first value is equal to or less than the operating upper limit voltage, the processor may change the charging completion voltage to the second value in act S964. In contrast, in a case where/when it is determined that the second value is above the operating upper limit voltage, the processor may change the charging completion voltage to the operating upper limit voltage in act S966.

Thereafter, the constant current charging or the constant power charging may be performed until the voltage value of the battery reaches the charging completion voltage (in some cases, the first value, the second value, or the operating upper limit voltage). In a case where the voltage value of the battery reaches the charging completion voltage, and/or based on determining that the voltage value reaches the charging completion voltage, the battery may be switched from the constant current charging or the constant power charging to the constant voltage charging in act S970. During the constant voltage charging, the voltage of the battery may be maintained at the charging completion voltage, and the current may be gradually reduced to reach a final current value, at which point the charging may be completed.

The flowchart of FIG. 9 and the above description are illustrative only, and the scope of the present disclosure is not limited thereto. According to other embodiments of the present disclosure, at least one step may be performed by a configuration other than the processor, at least one step may be added/altered/omitted, or the order of at least one step may be changed.

According to some embodiments, there is provided a charging control apparatus comprising: a memory configured to store one or more instructions for execution by a processor; and the processor, wherein when executing the instructions, the processor is configured to: determine a charging completion voltage of constant current charging or constant power charging as a first value based on a target charging energy of a battery; before a voltage value of the battery reaches the first value during the constant current charging or the constant power charging, determine whether a time point at which the voltage value of the battery reaches the first value is predicted to be near a local minimum point of a voltage rise rate of the battery; and maintain or change the charging completion voltage based on a result of determining whether the time point at which the voltage value of the battery reaches the first value is predicted to be near a local minimum point of the voltage rise rate of the battery.

Although the present disclosure has been described with reference to embodiments and drawings illustrating aspects thereof, the present disclosure is not limited thereto. Various modifications and variations can be made by a person skilled in the art to which the present disclosure belongs within the scope of the present disclosure and the claims and their equivalents, below.

## Claims

1. A charging control method (900) comprising:

   determining a charging completion voltage of constant current charging or of constant power charging as a first value based on a target charging energy of a battery (510);
   before a voltage value of the battery (510) reaches the first value during the constant current charging or the constant power charging, determining whether a time point at which the voltage value of the battery (510) reaches the first value is predicted to be near a local minimum point of a voltage rise rate of the battery (510); and maintaining or changing the charging completion voltage based on a result of determining whether the time point at which the voltage value of the battery (510) reaches the first value is predicted to be near the local minimum point of the voltage rise rate of the battery (510).

2. The charging control method (900) as claimed in claim 1, wherein the determining of whether the time point at which the voltage value of the battery (510) reaches the first value is predicted to be near the local minimum point of the voltage rise rate of the battery (510) comprises:

calculating at least one of a second derivative value or a third derivative value of a voltage of the battery (510) based on determining that the voltage value of the battery (510) reaches a first voltage of the first value minus a first predetermined value during the constant current charging or the constant power charging; and determining whether the time point at which the voltage value of the battery (510) reaches the first value is predicted to be near the local minimum point of the voltage rise rate of the battery (510) based on at least one of the second derivative value or the third derivative value.

3. The charging control method (900) as claimed in claim 1, wherein the determining of whether the time point at which the voltage value of the battery (510) reaches the first value is predicted to be near the local minimum point of the voltage rise rate of the battery (510) comprises:

calculating a second derivative value of a voltage of the battery (510) based on determining that the voltage value of the battery (510) reaches a first voltage comprising the first value minus a first predetermined value during the constant current charging or the constant power charging; and determining whether the second derivative value is positive.

4. The charging control method (900) as claimed in any one of claim 1 to 3, wherein the determining of whether the time point at which the voltage value of the battery (510) reaches the first value is predicted to be near the local minimum point of the voltage rise rate of the battery (510) further comprises: determining that the time point at which the voltage value of the battery (510) reaches the first value is not predicted to be near the local minimum point of the voltage rise rate of the battery (510) based on determining that the second derivative value is positive.

5. The charging control method (900) as claimed in any one of claim 1 to 3, wherein the determining of whether the time point at which the voltage value of the battery (510) reaches the first value is predicted to be near the local minimum point of the voltage rise rate of the battery (510) comprises:

calculating a third derivative value of the voltage of the battery (510) based on determining that the second derivative value is not positive; and determining whether the third derivative value is within a predetermined range.

6. The charging control method (900) as claimed in claim 5, wherein the determining of whether the third derivative value is within the predetermined range comprises: determining whether the third derivative value is greater than or equal to a second predetermined value.

7. The charging control method (900) as claimed in any one of the previous claims , wherein the determining of whether the time point at which the voltage value of the battery (510) reaches the first value is predicted to be near the local minimum point of the voltage rise rate of the battery (510) further comprises: determining that the time point at which the voltage value of the battery (510) reaches the first value is not predicted to be near the local minimum point of the voltage rise rate of the battery (510) based on determining that the third derivative value is not within the predetermined range.

8. The charging control method (900) as claimed in any one of the previous claims , wherein the determining of whether the time point at which the voltage value of the battery (510) reaches the first value is predicted to be near the local minimum point of the voltage rise rate of the battery (510) further comprises:

determining that the time point at which the voltage value of the battery (510) reaches the first value is predicted to be near the local minimum point of the voltage rise rate of the battery (510) based on determining that the third derivative value is within the predetermined range.

9. The charging control method (900) as claimed in any one of the previous claims, wherein the maintaining or the changing of the charging completion voltage comprises:
maintaining the charging completion voltage as the first value based on determining that the time point at which the voltage value of the battery (510) reaches the first value is not predicted to be near the local minimum point of the voltage rise rate of the battery (510).

10. The charging control method (900) as claimed in any one of the previous claims , wherein the maintaining or the changing of the charging completion voltage comprises:
changing the charging completion voltage to a second value based on determining that the time point at which the voltage value of the battery (510) reaches the first value is predicted to be near the local minimum point of the voltage rise rate of the battery (510).

11. The charging control method (900) as claimed in claim 10, wherein when the first value plus a third predetermined value is equal to or less than an operating upper limit voltage of the battery (510), the second value is the first value plus the third predetermined value, and
when the first value plus the third predetermined value is greater than the operating upper limit voltage of the battery (510), the second value is the operating upper limit voltage.

12. The charging control method (900) as claimed in claim 2, wherein the second derivative value comprises a value obtained by differentiating the voltage of the battery (510) twice by an amount of charge and/or time, and
the third derivative value comprises a value obtained by differentiating the voltage of the battery (510) three times by an amount of charge and/or time.

13. The charging control method (900) as claimed in any one of the previous claims , further comprising switching to constant voltage charging based on determining that the voltage value of the battery (510) reaches the charging completion voltage.

14. A charging control apparatus (520) comprising:

a memory (524) configured to store one or more instructions; and
a processor (522) configured to execute the stored one or more instructions to:

determine a charging completion voltage of constant current charging or constant power charging as a first value based on a target charging energy of a battery (510);
before a voltage value of the battery (510) reaches the first value during the constant current charging or the constant power charging, determine whether a time point at which the voltage value of the battery (510) reaches the first value is predicted to be near a local minimum point of a voltage rise rate of the battery (510); and
maintain or change the charging completion voltage based on a result of determining whether the time point at which the voltage value of the battery (510) reaches the first value is predicted to be near a local minimum point of the voltage rise rate of the battery (510).

15. The charging control apparatus (520) as claimed in claim 14, wherein, when executing the stored one or more instructions, the processor (522) is further configured to:

calculate at least one of a second derivative value or a third derivative value of a voltage of the battery (510) based on determining that the voltage value of the battery (510) reaches a first voltage of the first value minus a first predetermined value during the constant current charging or the constant power charging; and
determine whether the time point at which the voltage value of the battery (510) reaches the first value is predicted to be near the local minimum point of the voltage rise rate of the battery (510) based on at least one of the second derivative value or the third derivative value.

FIG. 1

FIG. 2

FIG. 3

FIG. 4

(A)

$V_B = V_R + V_C$

(B)

$V_B = CONSTANT$

(C)

$V_B = V_C$

(D)

FIG. 5

FIG. 6

700

FIG. 7

800

FIG. 8

900

START

S910
DETERMINE CHARGING COMPLETION VOLTAGE OF CC OR CP
CHARGING AS FIRST VALUE BASED ON TARGET CHARGING ENERGY

S920
CC OR CP CHARGING UNTIL VOLTAGE VALUE OF
BATTERY REACHES (FIRST VALUE - A)

S930
SECOND DERIVATIVE VALUE > 0?
YES
NO

S940
THIRD DERIVATIVE VALUE ≥ B?
NO
YES

S950
PREDICT TIME POINT AT WHICH VOLTAGE VALUE OF
BATTERY REACHES FIRST VALUE IS NOT NEAR LOCAL
MINIMUM POINT OF VOLTAGE RISE RATE OF BATTERY

S960
PREDICT TIME POINT AT WHICH VOLTAGE VALUE OF
BATTERY REACHES FIRST VALUE IS NEAR LOCAL
MINIMUM POINT OF VOLTAGE RISE RATE OF BATTERY

S962
SECOND VALUE
(= FIRST VALUE + C) ≤ OPERATING
UPPER LIMIT VOLTAGE?
YES
NO

S952
MAINTAIN CHARGING
COMPLETION VOLTAGE
AS FIRST VALUE

S964
CHANGE CHARGING
COMPLETION VOLTAGE
TO SECOND VALUE

S966
CHANGE CHARGING
COMPLETION VOLTAGE TO
OPERATING UPPER LIMIT VOLTAGE

S970
SWITCH TO CV CHARGING WHEN VOLTAGE VALUE OF
BATTERY REACHES CHARGING COMPLETION VOLTAGE

END

FIG. 9

Europäisches
Patentamt

European
Patent Office

Office européen
des brevets

# EUROPEAN SEARCH REPORT

**Application Number**

EP 25 15 2516

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 3 071 983 B1 (HRL LAB LLC [US]) 6 January 2021 (2021-01-06) * the whole document * | 1-15 | INV. H01M10/44 H02J7/00 |
| A | US 2022/179007 A1 (CHIDA AKIHIRO [JP] ET AL) 9 June 2022 (2022-06-09) * the whole document * | 1-15 | |
| A | CN 113 964 401 B (BEIJING JIAOTONG UNIV YANGTZE RIVER DELTA RESEARCH INSTITUTE) 20 October 2023 (2023-10-20) * the whole document * | 1-15 | |
| A | WO 2021/220393 A1 (TDK CORP [JP]) 4 November 2021 (2021-11-04) * the whole document * | 1-15 | |
| A | EP 3 358 704 B1 (SAMSUNG ELECTRONICS CO LTD [KR]) 16 October 2019 (2019-10-16) * the whole document * | 1-15 | |
| A | WO 2017/030309 A1 (LG CHEMICAL LTD [KR]) 23 February 2017 (2017-02-23) * the whole document * | 1-15 | **TECHNICAL FIELDS SEARCHED (IPC)** H01M H02J |

The present search report has been drawn up for all claims

| Place of search | Date of completion of the search | Examiner |
|---|---|---|
| Munich | 6 June 2025 | Pavlosyuk, Mikhail |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 15 2516

This annex lists the patent family members relating to the patent documents cited in the above-mentioned European search report.
The members are as contained in the European Patent Office EDP file on
The European Patent Office is in no way liable for these particulars which are merely given for the purpose of information.

06-06-2025

| Patent document cited in search report | | Publication date | Patent family member(s) | | Publication date |
|---|---|---|---|---|---|
| EP 3071983 | B1 | 06-01-2021 | CN | 105705958 A | 22-06-2016 |
| | | | EP | 3071983 A1 | 28-09-2016 |
| | | | EP | 3792645 A1 | 17-03-2021 |
| | | | US | 2015147614 A1 | 28-05-2015 |
| | | | WO | 2015077669 A1 | 28-05-2015 |
| US 2022179007 | A1 | 09-06-2022 | CN | 113646948 A | 12-11-2021 |
| | | | DE | 112020001752 T5 | 16-12-2021 |
| | | | JP | 2025000729 A | 07-01-2025 |
| | | | JP | WO2020201893 A1 | 08-10-2020 |
| | | | KR | 20210148217 A | 07-12-2021 |
| | | | US | 2022179007 A1 | 09-06-2022 |
| | | | WO | 2020201893 A1 | 08-10-2020 |
| CN 113964401 | B | 20-10-2023 | NONE | | |
| WO 2021220393 | A1 | 04-11-2021 | NONE | | |
| EP 3358704 | B1 | 16-10-2019 | CN | 108400632 A | 14-08-2018 |
| | | | EP | 3358704 A1 | 08-08-2018 |
| | | | JP | 7012544 B2 | 28-01-2022 |
| | | | JP | 2018130014 A | 16-08-2018 |
| | | | KR | 20180091541 A | 16-08-2018 |
| | | | US | 2018226693 A1 | 09-08-2018 |
| | | | US | 2021135479 A1 | 06-05-2021 |
| | | | US | 2023369663 A1 | 16-11-2023 |
| WO 2017030309 | A1 | 23-02-2017 | CN | 107710545 A | 16-02-2018 |
| | | | EP | 3287801 A1 | 28-02-2018 |
| | | | JP | 6498792 B2 | 10-04-2019 |
| | | | JP | 2018520622 A | 26-07-2018 |
| | | | KR | 20170021630 A | 28-02-2017 |
| | | | PL | 3287801 T3 | 30-09-2019 |
| | | | US | 2018292461 A1 | 11-10-2018 |
| | | | WO | 2017030309 A1 | 23-02-2017 |

EPO FORM P0459

For more details about this annex : see Official Journal of the European Patent Office, No. 12/82